# FASCICULE DE BREVET EUROPEEN

(11) **EP 2 875 517 B1**
(45) Date de publication et mention de la délivrance du brevet: **27.05.2020**
(21) Numéro de dépôt: 13756581.8
(22) Date de dépôt: 22.07.2013
(51) Int. Cl.: H01J 37/32

(54) **DISPOSITIF DE TRAITEMENT D'UN OBJET PAR PLASMA**
VORRICHTUNG ZUR BEHANDLUNG EINES OBJEKTS MIT PLASMA
DEVICE FOR TREATING AN OBJECT WITH PLASMA

(30) Priorité: 20.07.2012 FR 1257037
(43) Date de publication de la demande: 27.05.2015
(73) Titulaire: Plasma-Therm, LLC, St. Petersburg, FL 33716 (US)
(72) Inventeur: BAUJON, Gilles, F-75008 Paris (FR); GUIDOTTI, Emmanuel, F-75015 Paris (FR); PILLOUX, Yannick, F-77930 Perthes (FR); RABINZOHN, Patrick, F-74250 Fillinges (FR); RICHARD, Julien, F-91190 Gif Sur Yvettes (FR); SEGERS, Marc, F-91940 Les Ulis (FR); GIRAULT, Vincent, 28500 Vernouillet (FR)
(74) Mandataire: IP Trust
(86) Numéro de dépôt international: PCT/FR2013/051768
(87) Numéro de publication internationale: WO 2014/013209

(56) Documents cités:
- EP-A1- 1 936 656
- JP-A- 2007 088 509
- US-A- 5 273 609
- US-A- 5 296 272
- US-A1- 2005 178 746
- US-A1- 2006 124 588
- US-A1- 2007 090 092
- US-A1- 2007 181 421

## Description

### Domaine technique

L'invention concerne le domaine des traitements de surfaces par plasma.

Par traitement de surface par plasma, on entend, au sens de la présente invention, différents types d'applications.

On peut notamment citer les applications consistant en un retrait (ou gravure ou « *etch* » selon la terminologie Anglo-Saxonne) de matériaux (et en particulier de matériaux tels que des résines photosensibles, les métaux, les diélectriques, ou encore les semi-conducteurs...), la gravure de structures telles que des trous ou des tranchées dans un substrat de silicium ou une couche constituée de métaux, diélectriques ou autres, typiquement suivant un motif imprimé en surface dans une résine photosensible par photolithographie, ou encore les applications consistant en un retrait de couches sacrificielles.

On peut encore citer les applications consistant en un nettoyage de résidus et de contaminants, ou l'activation de surfaces (c'est à dire la modification physique et/ou chimique de « l'extrême surface »), ou encore la passivation de surfaces (c'est-à-dire la protection vis-à-vis d'attaques physiques et/ou chimiques de celles-ci)

Ces applications concernent notamment le domaine de la microélectronique et des semi-conducteurs, mais également la fabrication d'écrans plats et de cellules photovoltaïques par exemple.

### Etat de la technique

Un plasma est un gaz partiellement ionisé contenant des espèces chargées électriquement (ions et électrons) ainsi que des espèces neutres électriquement mais très actives chimiquement, les radicaux libres : ce sont des atomes et des molécules dans un état électronique « excité » mais n'ayant pas perdu d'électron. Grâce à ces radicaux et/ou ces ions et à un environnement sous vide contrôlé, le plasma offre des possibilités uniques pour le dépôt, la gravure et le retrait des matériaux.

A l'heure actuelle, il existe deux types de technologies plasma dominantes pour le traitement de surface des semi-conducteurs : les plasmas micro-ondes et les plasmas par couplage inductif. Ces technologies présentent chacune des avantages et des inconvénients.

Le principal avantage des plasmas micro-ondes vient de leur capacité à générer une haute densité d'espèces chimiques actives (supérieure à 10¹⁷ cm⁻³). Mais, cette technologie présente de nombreux inconvénients, tels que la complexité de la source plasma et la non-uniformité du traitement. La source plasma nécessite l'assemblage vertical de nombreuses pièces (guide d'onde, magnétron, ...), ce qui génère un encombrement important et la rend peu fiable. En outre, la source plasma est positionnée en amont (vis-à-vis du flux de gaz) et au centre d'une chambre de traitement, ce qui donne une uniformité insuffisante de la densité des espèces actives du plasma, et donc du traitement du substrat (disposé dans la chambre de traitement) entre le centre de la chambre (où la densité d'espèces actives est très élevée) et son bord (où la densité d'espèces actives est très faible). Par ailleurs, ce type de source plasma présente en outre l'inconvénient de nécessiter une puissance électrique très élevée, ainsi que des débits de gaz très élevés. Tous ces inconvénients rendent ce procédé plasma cher, difficile à fiabiliser et difficile à contrôler.

Les plasmas par couplage inductif (« *Inductively Coupled Plasma* » ou ICP selon la terminologie Anglo-Saxonne) sont plus faciles à mettre en œuvre que les plasma micro-ondes : la technologie est plus simple, moins chère et plus facilement contrôlable que la technologie micro-ondes. Toutefois, l'inconvénient principal de cette technologie vient de la faible densité d'espèces chimiques actives (d'environ 10¹⁵ cm⁻³) obtenue. En outre, tout comme les plasmas micro-ondes, les plasmas ICP souffrent d'un problème de non-uniformité de densité d'espèces actives entre le centre de la chambre (où la densité d'espèces actives est plus élevée) et son bord (où la densité d'espèces actives est plus faible), ce qui rend le traitement de la surface non uniforme. Les vitesses de traitement requises par les utilisateurs imposent d'utiliser une forte puissance pour les générateurs RF qui sont très couteux et provoque un échauffement des gaz mis en œuvre. Enfin, selon la conception de la chambre de traitement, le plasma généré par les sources ICP peut induire un bombardement ionique important des substrats (par exemple des plaques ou plaquettes de semi-conducteurs ou « *wafers* » selon la terminologie anglo-saxonne) volontaire (mode gravure ionique réactive ou « RIE » selon la terminologie Anglo-Saxonne) ou non.

Un des problèmes majeurs rencontrés par les technologies plasma actuelles est donc celui de la non-uniformité de la densité d'espèces actives, et par voie de conséquence celui de la conception de dispositif adaptés à l'augmentation de taille des substrats (ou de « *scale-up* » selon la terminologie Anglo-Saxonne). En effet, le passage de substrats de 200 mm de diamètre à des substrats de 300 mm de diamètre a déjà été difficile et très coûteux pour les fabricants d'équipements mettant en œuvre une technologie plasma. Ce changement de taille des substrats a en effet nécessité d'augmenter de façon considérable la taille des sources plasma, que ce soit des sources par couplage inductif (ou ICP) ou des sources micro-ondes, tout en rajoutant des pièces diverses tels que des diffuseurs ou des aimants pour réduire artificiellement le manque d'uniformité. Ces deux technologies (ICP et micro-ondes) sont donc aujourd'hui très coûteuses et complexes pour leurs utilisateurs, les fabricants de semi-conducteurs. Le passage de substrats de 300 mm de diamètre à des substrats de 450 mm de diamètre pose donc aujourd'hui des problèmes complexes de faisabilité.

Par ailleurs, les sources ICP et micro-ondes atteignent un taux de dissociation du gaz qui ne dépasse pas 30%, ce qui cause une dilution considérable des espèces actives générées, et une consommation de gaz très importante. Elles sont utilisées de façon unitaire : une seule source est utilisée par chambre de traitement et la taille de la source est proportionnelle au volume traité. Tout cela impose la mise en œuvre de sources volumineuses et qui fonctionnent à haute puissance, créant des effets thermiques indésirables sur les substrats et augmentant significativement le coût de ces systèmes. Parmi ces deux types de sources, les plasmas micro-ondes sont les plus denses pour ce qui est des espèces chimiques actives mais le contrôle du procédé est difficile.

Par conséquent, la technologie plasma ICP à moyenne densité d'espèces chimiques actives est aujourd'hui prédominante.

Par ailleurs, les plasmas contiennent, outre les radicaux libres qui sont électriquement neutres, des ions, des électrons et des radiations UV sous forme de photons énergétiques qui endommagent les dispositifs semi-conducteurs. Ces derniers deviennent de plus en plus sensibles à ces dommages au fur et à mesure de leur miniaturisation à l'échelle nanométrique.

La présence de métal sur le substrat (ou « wafer ») peut occasionner des risques de couplage avec les micro-ondes et un échauffement très important qui endommage les composants. Ceci est le cas des structures ultrasensibles des systèmes microélectromécaniques (également désignés par l'acronyme MEMS pour « *Micro Electro Mechanical Systems* » selon la terminologie Anglo-saxonne), ainsi que des assemblages et interconnexions en trois dimensions qui seront mises en œuvre dans les futures générations de semi-conducteurs.

Enfin, dans le cadre de la réalisation de circuits intégrés, il est connu de traiter par voie plasma des dispositifs semi-conducteurs constitués d'un assemblage de matériaux de nature très différente, se présentant notamment sous forme d'un empilement en couches minces. Pour fabriquer un circuit intégré à partir d'un dispositif semi-conducteur, le traitement plasma doit agir sur un seul matériau, en laissant inaffectés les autres matériaux de l'assemblage. C'est ce qu'on appelle la sélectivité. Cette caractéristique n'est pas suffisamment élevée à ce jour, ce qui dégrade la performance des composants.

Pour la réalisation de circuits intégrés sur une plaquette (ou « *wafer* ») de silicium (qui est le matériau de base habituellement utilisée pour fabriquer les plaquettes de circuits intégrés), le niveau d'intégration des circuits intégrés à l'échelle nanométrique impose aujourd'hui de nouvelles technologies de traitement de surface avec une sélectivité extrême, c'est à dire sans consommer les autres matériaux exposés.

Le problème de la sélectivité est particulièrement important avec l'utilisation d'empilement de grilles métalliques et de diélectriques de grille de type « *high-k* » et de réseaux d'interconnexion à diélectriques de type « *low-k* ». Ces matériaux sont particulièrement susceptibles de modifications physico-chimiques et de pertes de matière.

Jusqu'à présent, une légère perte de matière causée par le traitement de surface était tolérée car elle n'avait pas d'impact négatif sur les performances du circuit et l'objectif principal était de nettoyer tous les matériaux et contaminants indésirables. Aujourd'hui le traitement de surface, en particulier le retrait et le nettoyage, peuvent impacter directement les performances des circuits intégrés par la modification des dimensions et/ou des matériaux. Un objectif supplémentaire des traitements de surface est donc de minimiser et de contrôler ces modifications.

Les problèmes de sélectivité sont ainsi de plus en plus présents du fait de la diminution de la taille des circuits intégrés et de l'utilisation de nouveaux matériaux, en particulier pour les composants logiques (« *Logic* » selon la terminologie anglo-saxonne), typiquement les microprocesseurs, et les circuits mémoires.

Les technologies plasma actuelles souffrent donc de quatre inconvénients majeurs : endommagement des dispositifs par les espèces ionisées, faible densité d'espèces chimiques actives notamment pour les plasmas ICP, faible uniformité et manque de sélectivité.

Il existe donc un réel besoin d'un système de traitement plasma palliant ces défauts, inconvénients et obstacles de l'art antérieur et en particulier visant à augmenter la sélectivité des traitements plasma et à améliorer l'uniformité des traitements plasma notamment pour les substrats de grand diamètre tel que 300 ou 450 mm.

Il est connu de l'homme de l'art des systèmes de traitement plasma mettant en œuvre une pluralité de sources plasma, comme par exemple celui décrit dans la demande de brevet américain US20050178746 qui concerne un dispositif et une méthode pour dissocier un ou plusieurs gaz pour produire un plasma pour traiter un objet. Le brevet américain US5273609 divulgue un dispositif et une méthode de gravure avec des traitements plasma à multicanaux. Effectivement ce brevet décrit la gravure anisotropique séquentielle utilisant des plasmas différents venant des sources différentes. Le brevet japonais JP2007088509 décrit un système à plasma comprenant plusieurs sources à plasma générant des plasmas différents. Le but de ce brevet est d'améliorer l'homogénéité du plasma pour traiter des objets plus étendus.

### Description de l'invention

La présente invention a donc pour objet de fournir un procédé pour le traitement par plasma d'un objet qui remédie à ces inconvénients.

L'invention est telle que définie dans les revendications annexées

Selon l'invention, le plasma généré par un sous-ensemble est un gaz ou mélange gazeux partiellement ionisé de nature chimique différente du plasma généré par l'autre ou les autres sous-ensembles.

Avantageusement, chaque source de plasma d'un sous-ensemble comprend :
∘ un système d'entrée de gaz ;
∘ une chambre de décharge en un matériau inerte au plasma, par exemple sous forme de tube ;
∘ un dispositif de couplage de la puissance radiofréquence (RF) à la chambre de décharge ; et
∘ une sortie de gaz.

Avantageusement, un dispositif de contrôle pilote chacun des sous-ensembles selon un paramétrage spécifique par application de la puissance de radiofréquence Pi et/ou du débit de gaz ni spécifiques à chaque sous-ensemble.

Avantageusement, chaque sous-ensemble comprend une entrée de gaz propre au sous-ensemble reliée à l'entrée de gaz de chaque source de plasma du sous-ensemble.

Avantageusement, chaque sous-ensemble comprend un élément conducteur relié au dispositif de couplage de chaque source de plasma du sous-ensemble.

Avantageusement, les sous-ensembles sont disposés selon des anneaux concentriques.

Avantageusement, les sous-ensembles sont disposés en parallèle.

Avantageusement, dans chaque sous-ensemble comprenant au moins deux sources de plasma, chaque source de plasma comprenant au moins deux chambres de décharge en série.

La présente invention a encore pour objet un procédé de traitement sélectif par plasma d'un objet composite comportant au moins deux matériaux différents A et B, ledit procédé mettant en œuvre un système de traitement selon l'invention et comportant les étapes suivantes :
- une étape de génération d'un premier plasma par un premier des sous-ensembles, et le traitement à l'aide dudit premier plasma de l'objet ;
- une étape de génération d'un deuxième plasma par un second des sous-ensembles, et le traitement à l'aide dudit deuxième plasma de l'objet.

Par objet composite, on entend notamment, au sens de la présente invention un assemblage de matériaux de nature très différente, pouvant notamment se présenter sous forme d'un empilement en couches minces. A titre d'exemples d'objet composites pouvant être traités par le procédé de l'invention, on peut notamment citer les dispositifs semi-conducteurs, et en particulier les « *wafers* » de silicium, comportant les structures et matériaux des transistors et autres éléments constitutifs des circuits intégrés recouverts d'une ou plusieurs couches d'oxyde de silicium SiO₂ recouverts de nitrure de silicium Si₃N₄.

Avantageusement, les étapes de génération de plasmas sont répétées en alternance, ou avec recouvrement partiel ou total, et de préférence avec un recouvrement partiel des étapes d'au plus 25%.

Selon un mode de réalisation particulièrement avantageux, le procédé selon l'invention peut consister en un traitement de gravure de l'objet composite, ledit objet composite comportant au moins deux couches de matériaux différents A et B, la couche de matériau A recouvrant au moins partiellement la couche de matériau B, ledit procédé comportant :
- le traitement à l'aide du premier plasma d'au moins une première zone de l'objet comprenant en surface le matériau B, ledit traitement à l'aide du premier plasma consistant en une étape de passivation ou d'activation du matériau B ; et
- le traitement à l'aide du deuxième plasma d'au moins une deuxième zone de l'objet comprenant en surface le matériau A, ledit traitement à l'aide du deuxième plasma consistant en un retrait partiel ou total du matériau A pouvant conduire à la formation d'une zone comprenant le matériau B en surface lorsque le retrait est total A,
ledit procédé pouvant démarrer soit par l'étape de passivation ou d'activation à l'aide du premier plasma, soit par l'étape de retrait à l'aide du deuxième plasma.

A titre d'exemple d'objet composite pouvant être gravé sélectivement selon le procédé de l'invention, on peut en particulier citer les espaceurs (plus particulièrement l'amincissement ou le retrait des espaceurs), les structures STI (« *shallow trench Isolation* » selon la terminologie Anglo-saxonne) (plus particulièrement le retrait total ou partiel « *pull back* » selon la terminologie Anglo-saxonne du masque STI), les transistors et les circuits CMOS avancés (processeurs, mémoires) comprenant des couches de nitrure de silicium Si₃N₄ (matériau A) sur des couches d'oxyde de silicium SiO₂ (matériau B), le nitrure de silicium étant alors souvent un matériau sacrificiel.

Ce mode de réalisation du procédé selon l'invention présente l'avantage majeur d'allier une sélectivité élevée à une vitesse de gravure élevée.

Par sélectivité, on entend au sens de la présente invention, le rapport de la vitesse de gravure du matériau cible (matériau A, par exemple Si₃N₄) sur la vitesse de gravure d'un autre matériau exposé ou pouvant être exposé en cours de traitement (ici le matériau B, par exemple SiO₂), qui idéalement ne doit pas être gravé.

Il s'agit d'une propriété fondamentale des procédés de retrait de matière (ou gravure), qui est critique tant pour les procédés de type « *dry* » selon la terminologie anglo-saxonne tel que le procédé selon l'invention par voie plasma, que pour les procédés par voie humide (ou procédés « *wet* » selon la terminologie anglo-saxonne) à l'acide phosphorique par exemple.

Par exemple, la fabrication des circuits CMOS avancés (processeurs, mémoires) nécessite d'enlever le nitrure de silicium Si₃N₄ avec une sélectivité très élevée, en particulier vis-à-vis de SiO₂ et/ou Si : le retrait Si₃N₄ ne doit pas endommager les autres matériaux. A l'heure actuelle, les deux procédés utilisés pour réaliser cette étape de retrait du nitrure de silicium sont d'une part les procédés par voie humide (procédés dits « *wet* ») à l'acide phosphorique, et les procédés par voie plasma (procédés dits « *dry* ») avec un plasma fluorocarboné contenant un mélange gazeux CₓF_{y}H_{z}/O₂/H₂/N₂. Ces procédés actuels ne permettent pas de réaliser ce retrait du nitrure de silicium avec une sélectivité très élevée car elle n'est typiquement que de 50.

Par ailleurs, la réalisation d'un espaceur Si₃N₄ se fait par gravure directionnelle de la couche de Si₃N₄ déposée préalablement. Selon l'article scientifique Research *"*Plasma Etch Challenges for FinFET transistors" publié par la société Lam dans le Magazine Solid State Technology - Avril 2012 (pages 15, 16, 17 et 26)), la principale difficulté des procédés de gravure actuels réside dans l'obtention d'une forme d'espaceur très spécifique, sans consommer le substrat de silicium. La solution proposée dans cet article pour atteindre cet objectif consiste à moduler les conditions de plasma (« *time modulation of plasma parameters* »)*.* Par exemple, le puisage synchronisé (« *sync pulsing* » selon la terminologie Anglo-saxonne) est une technique consistant à switcher on/off la puissance RF source et la puissance RF du porte-substrat avec une période d'environ 100 ps. Ce type de gravure directionnelle est souvent utilisé pour le retrait ultérieur de l'espaceur. Toutefois, un tel procédé présente l'inconvénient d'induire une perte de silicium au pied de l'espaceur ainsi que le facetage des motifs voisins tels que le bord de zone active ou le bord de grille.

Le procédé de gravure selon l'invention résout les inconvénients de l'art antérieur et permet d'allier une grande sélectivité à une vitesse de gravure élevée.

Avantageusement, les étapes de traitement à l'aide du premier plasma et de traitement à l'aide du deuxième plasma sont réalisées de manière alternée selon une périodicité variant entre 0,5 seconde et 120 secondes, et de préférence de 2 à 30 secondes, de façon à répéter l'enchainement des étapes de traitement plasma une pluralité de fois jusqu'à obtention du retrait de matériau A souhaité.

Avantageusement, le rapport de la durée de l'étape d'activation ou de passivation sur la durée du retrait varie entre 0,1 à 10, et de préférence entre 0,5 et 2.

D'autres avantages et particularités de la présente invention résulteront de la description qui va suivre, donnée à titre d'exemple non limitatif et faite en référence aux figures annexées et aux exemples :
- la figure 1 est une vue fonctionnelle en coupe d'une chambre de traitement selon un mode de réalisation conforme à un système de traitement plasma de l'art antérieur ;
- la figure 2 est une vue fonctionnelle en coupe d'une source plasma du système présenté à la figure 1 ;
- la figure 3 est une vue fonctionnelle en perspective d'une configuration des sources plasma en deux sous-ensembles indépendants conformément à un mode de réalisation de l'invention ;
- la figure 4 une vue fonctionnelle en perspective d'une source plasma d'un système de traitement plasma selon un autre mode de réalisation de l'invention, comprenant deux chambres de décharge en série ;
- la figure 5 représente une machine de gravure plasma de l'art antérieur, qui est mise en œuvre dans l'exemple comparatif 2 ;
- la figure 6 représente une autre machine de gravure plasma de l'art antérieur, qui est mise en œuvre dans l'exemple comparatif 3 ;
- la figure 7 représente la sélectivité et la vitesse de gravure obtenues par le procédé mettant en œuvre la machine de la figure 6 (exemple comparatif 3) ;
- la figure 8 représente les évolutions de la vitesse de gravure et de la sélectivité en fonction du mélange gazeux mesurées au cours du déroulement du procédé mis en œuvre dans l'exemple comparatif 3 ;
- les figures 9 et 10 représentent l'utilisation de deux ensembles de sources plasma du dispositif selon l'invention mis en œuvre dans les exemples selon l'invention ;
- les figures 11A, 11B, 11C représentent le chronogramme de fonctionnement des deux sous-ensembles de la figure 10 ;
- les figures 12 à 14 représentent les résultats obtenus avec le procédé décrit dans les exemples selon l'invention et mettant en œuvre le dispositif schématiquement représenté sur les figures 9 et 10 ; et
- La figure 15 représente le résultat de la gravure selon le procédé décrit sur une couche d'oxyde de silicium recouvert de nitrure de silicium pour réaliser des structures composites d'isolement.

### Modes de réalisation particuliers

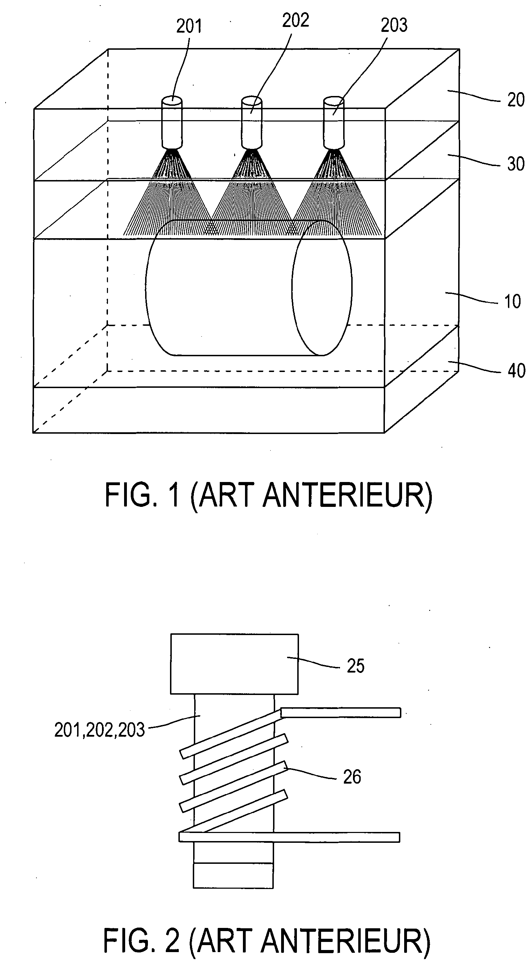

Tel que représenté sur la figure 1, un dispositif de traitement par plasma selon l'art antérieur comporte différents éléments : une chambre 10 de traitement, un ensemble 20 de sources plasma 201, 202, 203, un système de dispersion du gaz 30 et/ou d'isolement de la chambre de traitement 10 vis-à-vis des espèces endommageantes générées par chacune des sources de plasma, un système de confinement du gaz 31, et un système de pompage 40. La chambre de traitement 10 est constituée d'une enceinte en matériau spécialement traité pour ne pas ou peu interagir avec les espèces actives créées dans le plasma et de forme adaptée au traitement des pièces souhaitées, qui peut être cylindrique, cubique, ou d'une autre forme permettant l'utilisation industrielle de la chambre. L'une des faces de la chambre de traitement est dédiée au chargement. Il s'agit de la « porte ». D'autres faces sont dédiées à l'entrée des espèces, c'est là que sont fixées les sources plasma 201, 202, 203, et une autre face le plus souvent en vis-à-vis des sources ou à la base de la chambre 10 est dédiée au pompage de la chambre.

Chaque source plasma, telle que représentée à la figure 2, est ici constituée d'un système d'entrée de gaz 25, d'une chambre de décharge sous forme de tube de 201, 202, 203 en un matériau inerte au plasma et dont le diamètre est adapté pour optimiser le transfert de puissance radiofréquence par induction via un dispositif de couplage 26 (par exemple une antenne) à plusieurs spires branchées à une boite d'accord et un générateur RF en amont, et une capacité de décharge d'isolement en aval, non représentée.

Le vide dans la chambre de traitement 10, nécessaire à la création du plasma et à la circulation des gaz, est obtenu en pompant à l'aide d'une pompe 40. La pompe 40 est par exemple une pompe primaire ou turbomoléculaire reliée au bas de la chambre 10, le plus souvent face aux sources 201, 202, 203. Le gaz enrichi en espèces actives circule donc dans la chambre 10 avant d'être pompé.

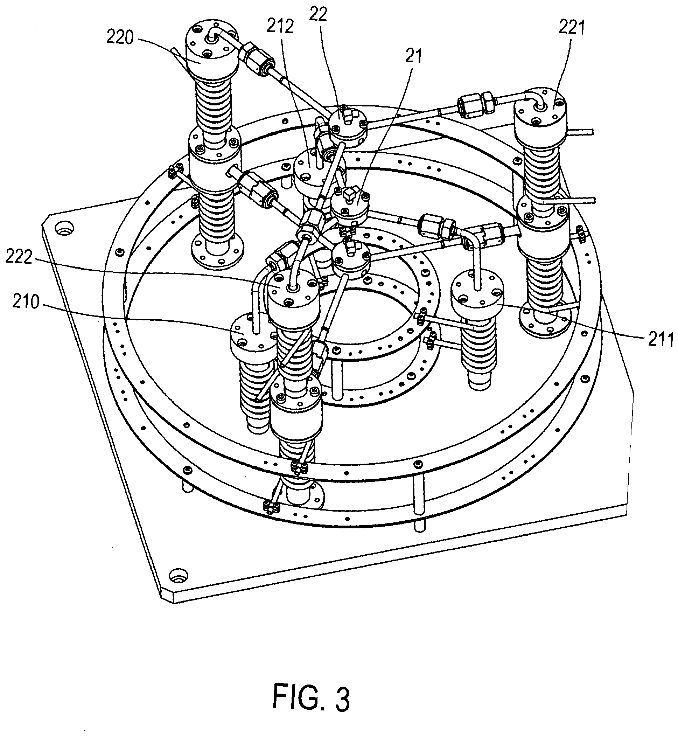

Sur la figure 3, est représentée une vue fonctionnelle en perspective d'une configuration des sources plasma en deux sous-ensembles indépendants 21, 22 conformément au procédé de traitement selon l'invention. Dans le mode de réalisation illustré sur la figure 3, les sous-ensembles 21, 22 sont disposés selon des anneaux concentriques. D'autres configurations sont toutefois possibles en fonction du résultat que l'on souhaite obtenir au final.

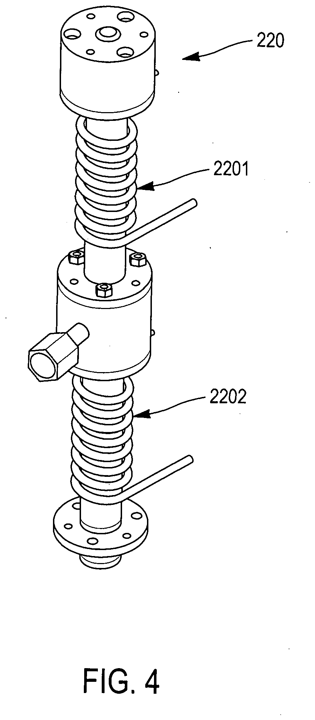

Chaque sous-ensemble 21, 22 comprend au moins une source de plasma permettant de générer un plasma. La figure 3 montre que chaque sous-ensemble comprend trois sources de plasma (210, 211 et 212 pour le sous-ensemble 21 et 220, 221 et 222 pour le sous-ensemble 22). Dans le sous-ensemble 21, chaque source comprend une seule chambre de décharge (ici sous forme de tube), tandis que dans le sous-ensemble 22, chaque source 220, 221 et 222 comprend deux chambres de décharge en série (ici sous forme de tubes également : tubes 2201 et 2202 comme illustré sur la figure 4).

Chaque source de plasma d'un sous-ensemble est alimentée par une puissance de radiofréquence Pi et par un gaz i de débit nᵢ indépendants. Le plasma généré par un sous-ensemble (par exemple le sous-ensemble 21) est un gaz ou un mélange gazeux partiellement ionisé de nature chimique différente du plasma généré par l'autre sous-ensemble 22.

Un dispositif de contrôle pilote chacun des sous-ensembles 21, 22 selon un paramétrage spécifique en appliquant une puissance de radiofréquence et un débit de gaz spécifique à chaque sous-ensemble.

Le système de traitement plasma permet donc de contrôler les sources plasma indépendamment les unes des autres en appliquant une puissance radiofréquence et/ou un débit de gaz différent à chaque sous-ensemble de sources, afin de pouvoir contrôler l'uniformité de traitement, notamment entre le centre et le bord d'une pièce à traiter.

Les différentes sources plasma 210, 211, 212, 220, 221, 222 sont avantageusement de petites tailles, avec des chambres de décharge de faible dimension, ici sous forme de tubes de faible diamètre, ce qui permet ainsi leur multiplication dans un sous-ensemble (dans le cas d'une source comprenant une seule chambre de décharge (ici sous forme de tube) ou la multiplication des sources (dans le cas d'une source comprenant des chambres de décharge en série).

La multiplication des sources permet par ailleurs d'augmenter le nombre des espèces actives générées par ce sous-ensemble dans la chambre de traitement. Elle permet également d'optimiser et d'homogénéiser les traitements même pour des plaques de grand diamètre. En effet, par la combinaison adéquate des cônes de diffusion des sources, en utilisant leur recouvrement et/ou leur superposition, ainsi que par la gestion de la circulation du gaz via le pompage de la chambre, il est possible d'obtenir un traitement uniforme des surfaces.

D'autre part, ces sources de plasma peuvent être placées à différents endroits stratégiques de façon à correspondre à la forme à traiter, pour une optimisation de son traitement ou de l'uniformité de son traitement.

Au regard de la configuration des sources plasma en sous-ensembles indépendants, de leur faible encombrement, ainsi que de la gestion indépendante des sous-ensembles, à la fois en gaz et en puissance radiofréquence, on peut allouer, dans le système de traitement plasma, différents sous-ensembles à différentes zones géométriques de la chambre de traitement. Ces zones étant indépendantes l'une de l'autre, elles sont plus ou moins activées, à la fois en gaz et en puissance radiofréquence, de façon à avoir un contrôle de l'action des espèces actives localisées dans la chambre de traitement 10.

Ainsi, en travaillant par zone et en sous-ensembles indépendants, on contrôle de façon active la géométrie du procédé.

Outre que cette disposition permet de contrôler l'uniformité du procédé à travers le substrat, le procédé est évolutif sans limites de taille d'objet à traiter, en particulier pour des diamètres de plaquettes (« *wafers* ») de 300 mm et 450 mm, en ajoutant des zones supplémentaires périphériques les unes aux autres.

Pour les substrats ou plaques de 300 mm de diamètre, on peut utiliser par exemple ici un système de traitement comportant deux sous-ensembles disposés selon deux anneaux concentriques, comme illustré sur la figure 3.

L'anneau central 21 est ici constitué de trois chambres de décharge (ici sous forme de tubes 210, 211 et 212) constituant les sources plasma (généralement entre une et six chambres de décharge) disposées au centre de la source et alimentées par une puissance radiofréquence P1 et par un gaz constitué d'un mélange de, par exemple, O₂, Ar, CF₄, CHF₃, NF₃, H₂O, H₂, Cl₂, CF₃Br, CₓH_{y}F_{z}..., mélangé dans un bloc F1, où F1 met en œuvre une opération de mélange à partir d'un gaz 1 de débit 1.1, d'un gaz 2 de débit 2.1, d'un gaz 3 de débit 3.1, etc. jusqu'à un gaz n de débit n.1.

Un deuxième anneau 22 entoure l'anneau central, qui est par exemple constitué de trois sources (mais de préférence entre quatre et huit sources), chacune constituée de deux chambres de décharge en série, l'anneau 22 étant concentrique à l'anneau central 21. Les différentes chambres de décharge (ici sous forme de tubes) de l'anneau 22 sont alimentées par une puissance radiofréquence P2 et par un gaz mélangé dans un bloc F2, ici un mélange de, par exemple, gaz O₂, Ar, CF₄, CHF₃, NF₃, H₂O, H₂, Cl₂, CF₃Br, CₓH_{y}F_{z} ..., où le bloc F2 met en œuvre une opération de mélange à partir d'un gaz 1 de débit 1.₂, d'un gaz 2 de débit 2.2, d'un gaz 3 de débit 3.₂, etc... jusqu'à un gaz n de débit n.2.

Il est aussi envisageable d'utiliser trois zones ou plus, en 300 mm.

Pour des plaques de 450 mm de diamètre, on pourra avantageusement ajouter un ou plusieurs anneaux concentriques de source plasma (chaque anneau correspondant à un sous-ensemble) ajouté(s) à ceux déjà existants en fonction des exigences d'uniformité en utilisant le même principe.

Par exemple, on pourra encore utiliser un troisième anneau 23 entourant le deuxième anneau 22 précédemment décrit, cet anneau 23 comportant de huit à seize chambres de décharge (ici sous forme de tubes), les tubes étant alimentés par une puissance radiofréquence P3 et alimentés par des gaz mélangés dans un bloc F3, lesquels gaz sont, par exemple, O₂, Ar, CF₄, CHF₃, NF₃, H₂O, H₂, Cl₂, CF₃Br, CₓH_{y}F_{z}, etc, où le bloc F3 met en œuvre une opération de mélange à partir d'un gaz 1 de débit 1.3, d'un gaz 2 de débit 2.3, d'un gaz 3 de débit 3.3, etc. jusqu'à un gaz n de débit n.3.

L'uniformité des processus est assurée par le contrôle indépendant des différentes zones de la source en termes de débit de gaz F1, F2, F3 et de puissance radiofréquence P1, P2, P3.

Pour cela, chaque anneau correspond à un sous-ensemble de sources, lequel sous-ensemble comprend une entrée de gaz qui est propre au sous-ensemble, reliée à l'entrée de gaz de chaque source de plasma du sous-ensemble considéré. Un dispositif de contrôle pilote le débit de gaz dans l'entrée de gaz de chaque sous-ensemble. Le dispositif de contrôle pilote en outre le mélange de gaz injecté dans l'entrée de gaz de chaque sous-ensemble.

En termes d'implémentation électrique, chaque sous-ensemble comprend ici un élément conducteur relié à l'antenne 26 de chaque chambre de décharge (ici sous forme de tube) du sous-ensemble. Le dispositif de contrôle pilote la puissance RF fournie à l'élément conducteur d'un sous-ensemble.

Selon une disposition avantageuse, on met en outre le substrat en mouvement de rotation pour moyenner la vitesse de traitement et ainsi améliorer l'uniformité.

Selon une autre disposition avantageuse, on ajoute des anneaux concentriques en aluminium anodisé ou en quartz typiquement entre chaque source et le substrat à traiter, typiquement en partie supérieure de la chambre de traitement 10, ces anneaux étant des têtes de douches (ou « *showerhead* » selon la terminologie anglo-saxonne) lesquels sont couramment utilisés dans les équipements de fabrication des semi-conducteurs pour répartir l'injection des espèces chimiques en des centaines de points d'injection. De tels anneaux forment des petits trous percés dans leur face inférieure, en vis-à-vis du substrat à traiter. Dans le cas présent ils permettent d'améliorer encore plus l'uniformité du traitement voire même de réduire le nombre de chambres de décharge nécessaire pour traiter un substrat de 300 et 450 mm.

Selon une autre disposition avantageuse, on ajuste les paramètres de débit de gaz et de puissance radiofréquence à partir d'une mesure de performance en termes d'uniformité du procédé.

En utilisant un dispositif de mesure des performances locales du procédé, qu'il soit direct par exemple par spectroscopie ou indirect par exemple par mesure d'épaisseur, on peut, grâce au multiplexage des sources, activement corriger le procédé de façon à optimiser la qualité du traitement en termes de vitesse, d'homogénéité et d'uniformité tout en garantissant l'innocuité du traitement.

Un tel ajustement des paramètres de flux de gaz et de puissance radiofréquence est par exemple réalisé sous forme d'une boucle fermée ou sous forme d'une boucle en avance ou « *Feed Forward* » selon la terminologie Anglo-Saxonne.

Un ajustement en « *Feed Forward* » consiste ici à mesurer l'état de surface du wafer avant traitement (comme l'épaisseur de résine par exemple) afin d'ajuster les paramètres du procédé pour compenser la non-uniformité déjà présente.

La boucle fermée consiste ici à mesurer l'état de surface du wafer après traitement afin d'ajuster les paramètres du procédé avant de traiter le wafer suivant.

Les avantages apportés par le système de traitement plasma décrit sont notamment une meilleure uniformité et une meilleure efficacité en termes de vitesse de traitement. De plus, le multiplexage des sources permet le contrôle indépendant du flux d'espèces actives en termes de quantité, de taux de dissociation, de composition chimique, et d'énergie sur certaines zones de travail, et permet ainsi de corriger de façon active le traitement des composants sensibles. Le système permet donc de traiter des substrats sans limite de taille, ce qui procure un potentiel très large d'applications, au-delà des applications de nettoyage et de retrait (ou « *stripping* » selon la terminologie Anglo-saxonne).

Le système permet également une distribution uniforme du flux gazeux d'espèces actives. Il permet d'améliorer l'efficacité de nettoyage des résidus et les vitesses de gravure, tout en augmentant considérablement la sélectivité par rapport aux performances actuelles.

La sélectivité est le rapport de la vitesse de gravure du matériau cible (par exemple du nitrure de silicium Si₃N₄) sur la vitesse de gravure d'un autre matériau exposé, qui idéalement ne doit pas être gravé (par exemple de l'oxyde de silicium SiO₂). La sélectivité est critique et doit être constamment augmentée, au fur et à mesure de l'apparition de nouvelles générations technologiques. Le dispositif, avec ses multiples chambres de décharge (ici sous forme de tubes) permet d'augmenter la sélectivité des procédés plasma en contrôlant indépendamment la vitesse de gravure du matériau cible et celle du (des) autres(s) matériau(x) exposé(s). Le dispositif permet d'obtenir une sélectivité infinie.

En particulier, l'utilisation alternée, ou en recouvrement partiel d'un plasma de retrait généré par un sous-ensemble et d'un plasma de passivation généré par un autre sous-ensemble permet d'améliorer substantiellement cette sélectivité.

### EXEMPLES

### Produits

- Substrats semi-conducteurs (« *wafers* ») en silicium, recouvert d'une couche de nitrure de silicium (Si₃N₄) comme matériau cible à graver, et d'une couche d'oxyde de silicium SiO₂ comme matériau à ne pas graver, ou de zones composites des matériaux précédents ;
- Substrats semi-conducteurs (« *wafers* ») en silicium recouvert d'une couche d'oxyde de silicium SiO₂ (matériau à ne pas graver) recouverte d'une couche de Si₃N₄ (matériau cible à graver) ;
- Substrats semi-conducteurs (« *wafers* ») en silicium comportant des zones composites des empilements précédents

### Test : mesure de la sélectivité

La sélectivité est mesurée en faisant le ratio, après traitement, de l'épaisseur enlevée sur le matériau A par rapport à l'épaisseur enlevée sur le matériau B pour une même durée de traitement. Cela peut également s'exprimer sous forme du rapport des vitesses de gravure ou retrait des deux matériaux.

### EXEMPLE COMPARATIF 1

Des substrats de silicium recouverts d'une couche de nitrure de silicium (Si₃N₄) et des substrats de silicium recouverts d'une couche d'oxyde de silicium (SiO₂) ont été respectivement gravés par voie humide à l'acide phosphorique.

### Résultats

On obtient une sélectivité de 50 : 1

### EXEMPLE COMPARATIF 2

Pour déterminer la vitesse de gravure de Si02 on utilise un substrat Si recouvert de Si02 seulement i.e. Si02/Si, duquel on retire partiellement le Si02. Pour déterminer la vitesse de gravure de Si3N4 on utilise un substrat Si recouvert de Si3N4 seulement i.e. Si3N4/Si ou le plus souvent un substrat Si avec du Si3N4 sur Si02 i.e. Si3N4/SiO2/Si duquel on retire partiellement le Si3N4.

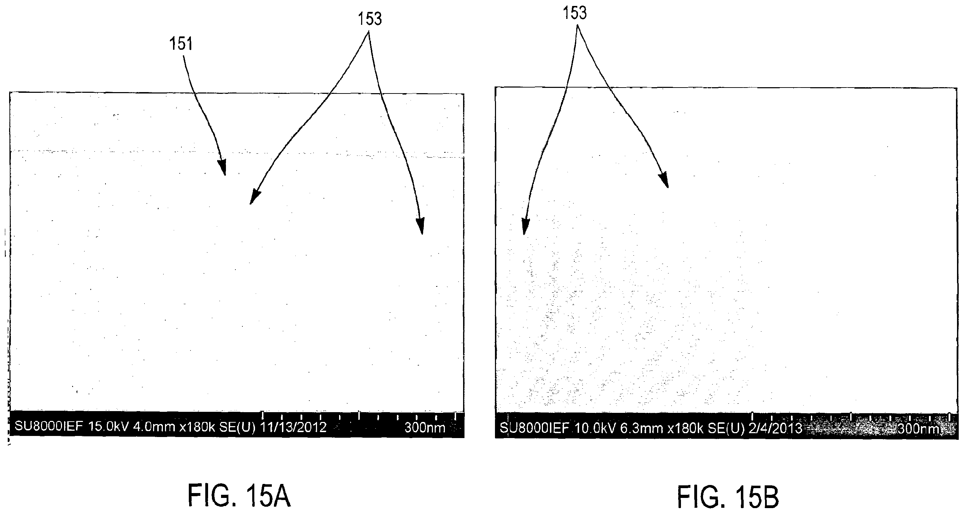

Ensuite on applique le procédé a la structure réelle sur substrat Si. La structure réelle est le plus souvent composite, c'est-à-dire faite de zones Si02 et de zones Si3N4/SiO2. La géométrie et la topographie des zones dépendent de l'étape de fabrication (la figure 15 en est un exemple).

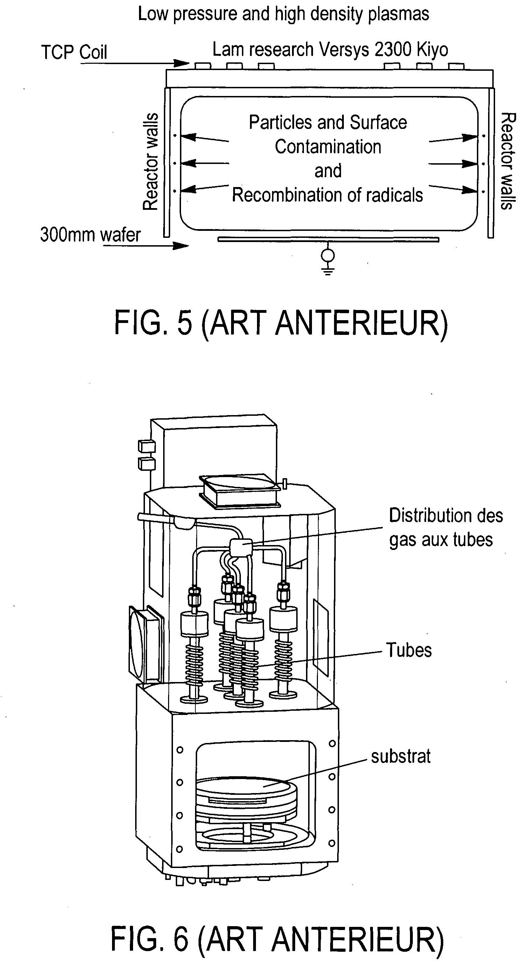

Des plaquettes de test comme ci-dessus ont été gravées par le procédé plasma de l'art antérieur présenté par le centre de R&D IMEC (Belgique) lors de la conférence PESM 2012 à Grenoble. Les traitements de gravure plasma ont été réalisés dans une machine de gravure de la société LAM RESEARCH tel qu'illustrée sur la figure 5 : elle comprend une seule chambre de décharge et une seule chimie.

### Résultats

| | |
|---|---|
| • plasma (mélange de gaz utilisé) | NF₃/O₂/CH₃F |
| • Vitesse v1 de gravure de Si₃N₄ | 44 nm/min |
| • Vitesse v2 de gravure de SiO₂ | 0.8 nm/min |
| • Sélectivité v1/v2 | 55:1 |

### EXEMPLE COMPARATIF 3

Le déposant a réalisé des expériences de gravure sélective de Si₃N₄ en se basant sur un équipement comportant une source plasma composée de plusieurs chambres de décharge (ici sous forme de tubes) tel qu'illustré sur la figure 6. Dans ce dispositif, les tubes de décharge sont tous connectés en parallèle et contrôlés avec un seul générateur. Il n'est pas possible de contrôler indépendamment les tubes, c'est-à-dire d'appliquer une puissance RF différente aux différents tubes. Les gaz actifs de type O₂, N₂, CF₄... sont mélangés avant d'être injectés dans les tubes de décharge. Il n'est également pas possible d'injecter différents gaz aux différents tubes. La source plasma utilisée par le déposant, bien que composée de plusieurs tubes de décharge, génère un seul type de plasma dans la chambre de traitement, tout comme les sources plasma traditionnelles (micro-ondes ou par couplage inductif).

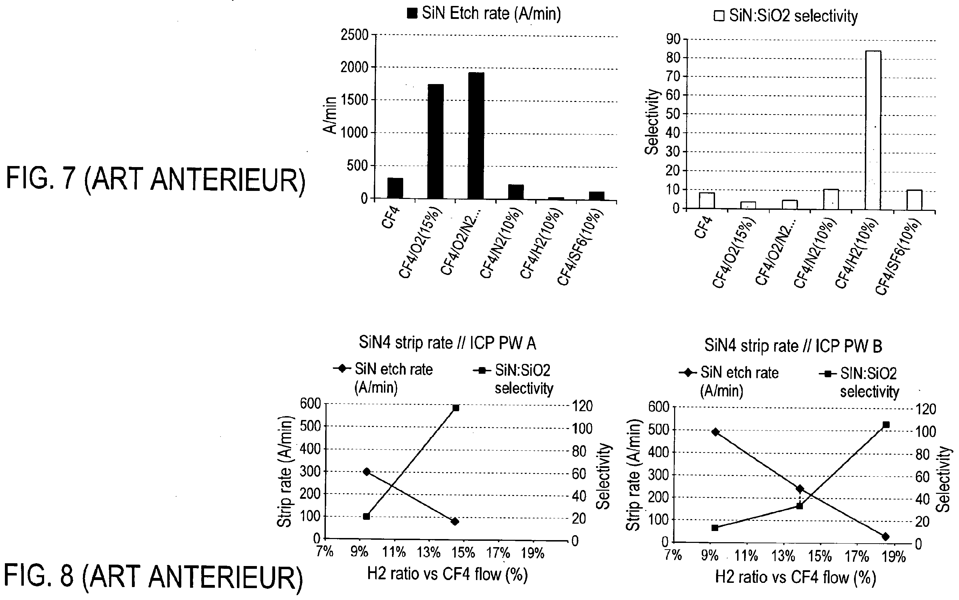

La figure 7 montre la sélectivité et la vitesse de gravure en fonction de différents mélanges gazeux. Cette figure montre que :
- l'ajout d'O₂ est le paramètre principal pour augmenter la vitesse de gravure de Si₃N₄; et
- l'ajout de H₂ améliore grandement la sélectivité Si₃N₄: SiO₂, mais la vitesse de gravure de Si₃N₄ reste faible.

La figure 8 montre la sélectivité et la vitesse de gravure en fonction du taux de H₂ dans le mélange gazeux. On constate que :
- la vitesse de gravure de Si₃N₄ et la sélectivité Si₃N₄: SiO₂ sont étroitement corrélées : la vitesse de gravure de Si₃N₄ diminue quand la sélectivité à SiO₂ augmente. Il n'est pas possible de décorréler les deux dans une configuration de source plasma traditionnelle (c'est-à-dire générant un seul type de plasma dans la chambre de traitement) ;
- la vitesse de gravure de Si₃N₄ est d'environ 80 Å/min pour une sélectivité Si₃N₄: SiO₂ de 110:1 ;
- La vitesse de gravure de Si₃N₄ est d'environ 250 Å/min pour une sélectivité Si₃N₄: SiO₂ d'environ 35:1.

Les exemples comparatifs montrent donc qu'il n'est pas possible d'allier une sélectivité élevée avec une vitesse de gravure élevée (voir les résultats présentés sur la figure 8 et l'exemple comparatif 2).

### EXEMPLE 1 SELON L'INVENTION

Des substrats de silicium recouverts d'oxyde de silicium et/ou recouverts de nitrure de silicium (Si₃N₄/ SiO₂) tels que décrits précédemment ont été gravés conformément au procédé de gravure plasma selon un mode de réalisation de l'invention, comprenant la répétition des deux étapes fondamentales suivantes jusqu'à obtention du résultat escompté :
- étape de passivation : elle sert à protéger certaines surfaces (« ou passiver ») de l'attaque chimique ayant lieu lors de l'étape de gravure. La passivation consiste à déposer sur le substrat un polymère de type CₓF_{y}H_{z} par exemple (par exemple CF₄, ou C₄F₈ ou C₂F₆, CHF₃, CH₃F, ...
- étape de retrait ou gravure : Elle sert à retirer (« graver ») un matériau, soit partiellement ou entièrement. Durant l'étape 2, la couche de passivation peut être partiellement ou complètement retirée,
la durée de chaque étape étant de l'ordre de quelques secondes voire de quelques dizaines de secondes mais pouvant également être extrêmement courte, de l'ordre de 0,1 s.

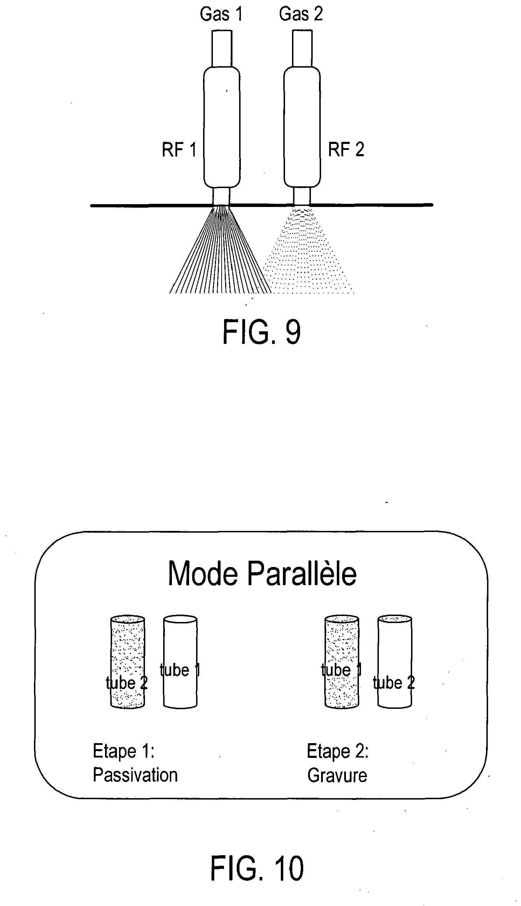

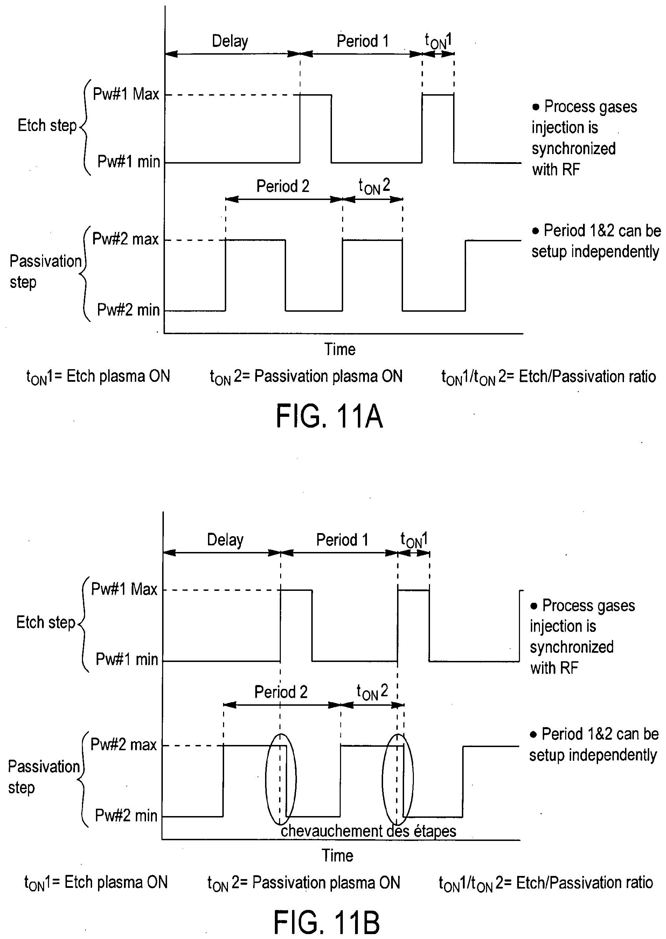

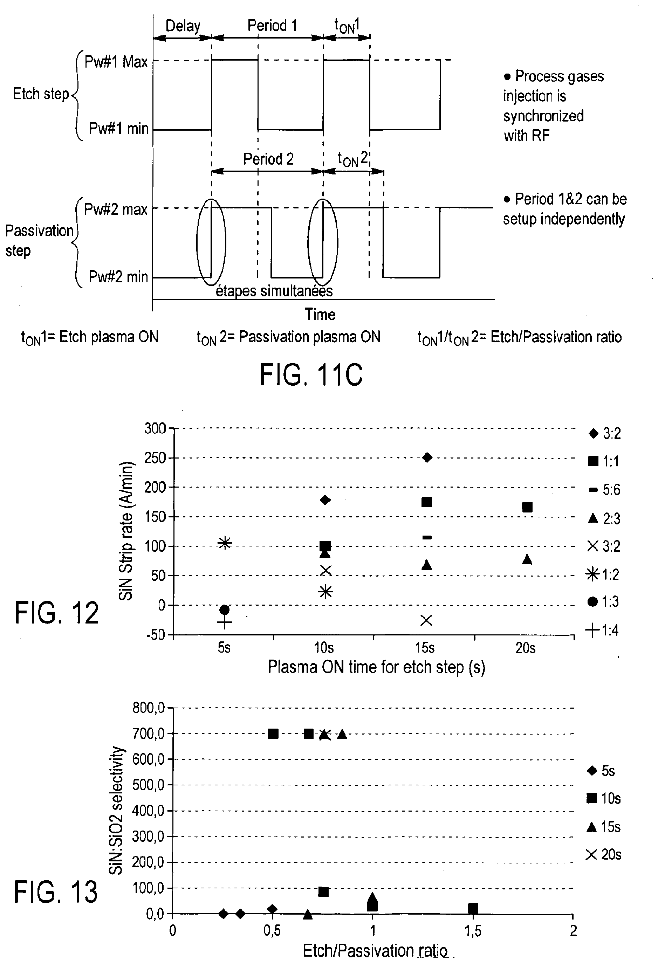

Ce procédé est mis en œuvre à l'aide d'un dispositif de traitement plasma selon l'invention comprenant deux sous-ensembles de sources de plasma différentes (ici représentés par les tubes 1 et 2 sur la figure 9), chaque tube réalisant une étape (passivation ou gravure) de l'invention (comme illustré sur la figure 10). Les chronogrammes de fonctionnement de chaque source sont représentés sur les figures 11A, 11B et 11C, respectivement pour un fonctionnement avec des étapes de retrait et de passivation alternées sans aucun recouvrement, (figure 11A), pour un fonctionnement avec des étapes de passivation et de retrait se chevauchant partiellement (figure 11B) et des étapes de retrait et de passivation se chevauchant complètement (figure 11C).

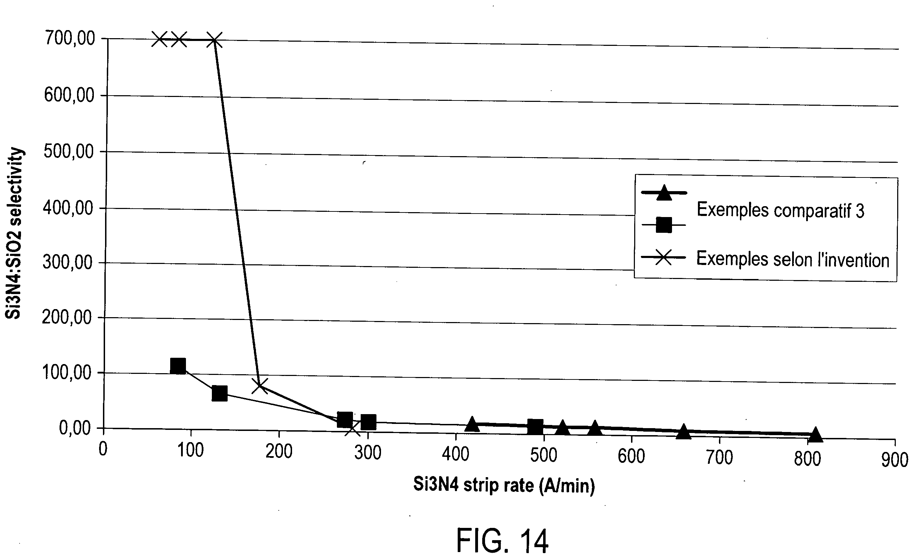

Comme le montrent les figures 12 à 14,
- le procédé décrit permet de contrôler la vitesse de gravure de Si₃N₄ sans consommation apparente de SiO₂ ;
- la vitesse de gravure de Si₃N₄ est de -120 Â/min pour une sélectivité Si₃N₄: SiO₂ de -700:1 avec un plasma CF₄/O₂/H₂.

Ces essais montrent donc que le procédé de gravure plasma selon l'invention permet de pouvoir contrôler indépendamment la vitesse de gravure de Si₃N₄ et celle de SiO₂ et d'obtenir ainsi une sélectivité très élevée.

Les conditions expérimentales des essais de gravure selon l'invention sont détaillées ci-dessous et illustrées sur les figures 11A, 11B et 11C.

| Procédés utilisés par tube: | valeurs | min | Max |
|---|---|---|---|
| **Etape de passivation (Tube 2) :** | | | |
| Conditions 1 | | | |
| - Puissance RF = | 120 W | 80 | 360 |
| - Débit CF₄ = | 40 sccm | 20 | 80 |
| - Débit H₂ = | 13,5 sccm | 5 | 30 |
| - tON₂ = | 20 sec | 2 | 35 |
| - Period 2 = | 35 sec | 3 | 80 |
| ou | | | |

| Conditions 2 | | | |
|---|---|---|---|
| - Puissance RF = | 360 W | 120 | 360 |
| - Débit C₄F₈ = | 45 sccm | 20 | 50 |
| - Débit _{.O2}= | 5 sccm | 0 | 20 |
| - tON₂ = | 20 sec | 2 | 35 |
| - Period 2 = | 35 sec | 3 | 80 |
| ou | | | |

| Conditions 3 | | | |
|---|---|---|---|
| - Puissance RF = | 240 W | 120 | 360 |
| - Débit C₂F₆ = | 30 sccm | 30 | 70 |
| - Débit O₂= | 0 sccm | 0 | 5 |
| - tON₂ = | 20 sec | 2 | 35 |
| - Period 2 = | 35 sec | 3 | 50 |

| **Etape de retrait (Tube 1)** | | | |
|---|---|---|---|
| Conditions 1 | | | |
| - Puissance RF = | 120 W | 120 | 360 |
| - Débit CF₄ = | 40 sccm | 20 | 80 |
| - Débit O₂ = | 5 sccm | 0 | 10 |
| - tON₁ = | 15 sec | 1 | 35 |
| - Period 1 = | 35 sec | 3 | 85 |
| ou | | | |

| Conditions 2 | | | |
|---|---|---|---|
| - Puissance RF = | 240 W | 120 | 360 |
| - Débit CHF₃ = | 40 sccm | 0 | 100 |
| - Débit O₂ = | 30 sccm | 0 | 60 |
| - tON₁ = | 15 sec | 1 | 35 |
| - Period 1 = | 35 sec | 3 | 85 |

### Autres paramètres :

| | |
|---|---|
| - Température du substrat = | entre 135°C et 150°C |
| - Pression = | 200 mTorr à 1Torr |
| - Temps total du procédé = | de 1 min à 3 min |
| - Puissance RF = 50 à 1000W / tube de décharge et jusqu'à 5000W pour un sous-ensemble composé de plusieurs tubes de décharge. | |
| - Débit de gaz = 1 sccm à 5000 sccm | |
| - tON= 0.1 sec à 30 sec | |

### Autres gaz plasma pouvant être utilisés dans le cadre de la présente invention :

- pour l'étape de passivation : CF₄, CHF₃, CH₃F, C₂F₆, C₄F₈, CF₃Br, HBr avec ou sans H₂, avec ou sans N₂, et leurs mélanges
- pour l'étape de gravure : CF₄, CHF₃, CH₃F, NF₃, Cl₂, HBr, SF₆, avec ou sans O₂, avec ou sans N₂, et leurs mélanges
- Gaz additifs: O₂, N₂, Ar, H₂, Xe, He

### EXEMPLE 2 SELON L'INVENTION

A partir de substrats constitués de silicium recouverts d'oxyde de silicium et/ou recouverts de nitrure de silicium, on grave sélectivement la couche de nitrure de silicium Si₃N₄ servant de masque pour la réalisation de structures composites d'isolement dites STI (« *shallow trench Isolation* » selon la terminologie Anglo-Saxonne).

Pour cela, on répète huit fois consécutivement la séquence des étapes de passivation et de retrait mettant en œuvre les conditions 1 de l'exemple 1 pour une durée respective de 7 et 15 s. La structure composite avant retrait est illustrée à la figure 15A (gauche), tandis que celle après traitement est illustrée à la figure 15B (droite). Le nitrure de silicium Si₃N₄ est référencé 151 et l'oxyde de silicium 153. On constate une suppression du nitrure de silicium alors que l'oxyde de silicium est intact.

## Revendications

1. Procédé de traitement sélectif de gravure par plasma d'un objet composite (3) comportant au moins deux couches de matériaux différents A et B, la couche de matériau A recouvrant au moins partiellement la couche de matériau B, ledit procédé mettant en œuvre un système de traitement comprenant :
- une chambre de traitement sous vide (10) comprenant un support sur lequel est disposé l'objet à traiter ; et
- au moins deux sous-ensembles (21,22) comprenant chacun au moins une source plasma (210, 220) permettant de générer un plasma, chaque source de plasma (210, 220) d'un sous-ensemble (21, 22) étant alimentée par une puissance radiofréquence Pi et par un gaz i de débit ni, indépendamment de l'autre ou des autres sous-ensemble(s) ; le plasma généré par un sous-ensemble (21) étant un gaz ou mélange gazeux partiellement ionisé de nature chimique différente du plasma généré par l'autre ou les autres sous-ensemble(s) (22),
le procédé comportant les étapes suivantes :
• une étape de génération d'un premier plasma par un premier des sous-ensembles (21), et le traitement à l'aide du premier plasma d'au moins une première zone de l'objet (3) comprenant en surface le matériau B, ledit traitement à l'aide du premier plasma consistant en une étape de passivation ou d'activation du matériau B ;
• une étape de génération d'un deuxième plasma par un second des sous-ensembles (22), et le traitement à l'aide du deuxième plasma d'au moins une deuxième zone dudit objet (3) comprenant en surface le matériau A, ledit traitement à l'aide du deuxième plasma consistant en un retrait partiel ou total du matériau A, ledit procédé pouvant démarrer soit par l'étape de passivation ou d'activation à l'aide du premier plasma, soit par l'étape de retrait à l'aide du deuxième plasma.

2. Procédé selon la revendication précédente, dans lequel les étapes de génération de plasmas sont répétées en alternance, ou avec recouvrement partiel ou total.

3. Procédé selon l'une des revendications précédentes, dans lequel les étapes de génération de plasmas sont répétées avec un recouvrement partiel des étapes d'au plus 25%.

4. Procédé selon l'une des revendications précédentes, dans lequel les étapes de traitement à l'aide du premier plasma et de traitement à l'aide du deuxième plasma sont réalisées de manière alternée selon une périodicité variant entre 0,5 seconde et 120 secondes, et de préférence de 2 à 30 secondes, de façon à répéter l'enchaînement desdites étapes une pluralité de fois jusqu'à obtention du retrait de matériau A souhaité.

5. Procédé selon l'une des revendications précédentes, dans lequel le rapport de la durée de l'étape d'activation ou de passivation sur la durée du retrait varie entre 0,1 à 10, et de préférence entre 0,5 et 2.

6. Procédé selon l'une quelconque des revendications précédentes, dans lequel le premier matériau A est du nitrure de silicium Si3N4 et le second matériau B est de l'oxyde de silicium SiO2.

7. Procédé selon l'une des revendications précédentes, dans lequel le premier et le deuxième sous-ensembles (21, 22) du système de traitement sont disposés selon des anneaux concentriques :
- le premier sous-ensemble (21) comportant entre trois et six sources de plasma disposées selon un anneau central, chaque source de plasma comprenant une chambre de décharge,
- le deuxième sous-ensemble (22) comportant entre trois et huit sources de plasma disposées selon un deuxième anneau entourant l'anneau central, chaque source de plasma comprenant deux chambres de décharge en série.

8. Procédé selon la revendication précédente, dans lequel le système de traitement comprend un ou plusieurs anneau(x) concentrique(s) additionnel(s), chacun correspondant à un sous-ensemble additionnel.

## Patentansprüche

1. Verfahren zur selektiven Plasmaätzbehandlung eines Verbundgegenstands (3), der mindestens zwei Schichten aus unterschiedlichen Materialien A und B umfasst, wobei die Materialschicht A die Materialschicht B zumindest teilweise bedeckt, wobei das Verfahren ein Bearbeitungssystem anwendet, umfassend:
- eine Vakuumbehandlungskammer (10) mit einem Träger, auf dem der zu behandelnde Gegenstand angeordnet ist; und
- mindestens zwei Unterbaugruppen (21, 22), die jeweils mindestens eine Plasmaquelle (210, 220) zum Erzeugen eines Plasmas umfassen, wobei jede Plasmaquelle (210, 220) einer Unterbaugruppe (21, 22) unabhängig von der oder den anderen Untergruppe(n) mit einer Hochfrequenzleistung Pi und einem Gas i mit einem Durchsatz ni versorgt wird; wobei das von einer Unterbaugruppe (21) erzeugte Plasma ein teilweise ionisiertes Gas oder Gasgemisch anderer chemischer Art als das von der oder den anderen Unterbaugruppe(n) (22) erzeugte Plasma ist,
wobei das Verfahren die folgenden Schritte umfasst:
• einen Schritt zur Erzeugung eines ersten Plasmas durch eine erste der Unterbaugruppen (21), und die Behandlung mindestens einer ersten Zone des Gegenstands (3), die auf ihrer Oberfläche das Material B umfasst, mit dem ersten Plasma, wobei die Behandlung unter Verwendung des ersten Plasmas aus einem Schritt der Passivierung oder Aktivierung des Materials B besteht;
• einen Schritt zur Erzeugung eines zweiten Plasmas durch eine zweite der Unterbaugruppen (22), und die Behandlung mindestens einer zweiten Zone des Gegenstandes (3), die auf ihrer Oberfläche das Material A umfasst, mit dem zweiten Plasma, wobei die Behandlung unter Verwendung des zweiten Plasmas aus einer teilweisen oder vollständigen Entfernung des Materials A besteht, wobei das Verfahren entweder durch den Schritt der Passivierung oder Aktivierung unter Verwendung des ersten Plasmas oder durch den Schritt der Entfernung unter Verwendung des zweiten Plasmas begonnen werden kann.

2. Verfahren nach dem vorhergehenden Anspruch, wobei die Schritte zur Erzeugung von Plasmen abwechselnd oder mit teilweiser oder vollständiger Überlappung wiederholt werden.

3. Verfahren nach einem der vorhergehenden Ansprüche, wobei die Schritte zur Erzeugung von Plasmen mit einer teilweisen Überlappung der Schritte von höchstens 25 % wiederholt werden.

4. Verfahren nach einem der vorhergehenden Ansprüche, wobei die Schritte der Behandlung unter Verwendung des ersten Plasmas und der Behandlung unter Verwendung des zweiten Plasmas abwechselnd in Intervallen von 0,5 Sekunden bis 120 Sekunden und vorzugsweise 2 bis 30 Sekunden variieren, um die Abfolge der Schritte mehrmals zu wiederholen, bis die gewünschte Entfernung des Materials A erreicht wird.

5. Verfahren nach einem der vorhergehenden Ansprüche, wobei das Verhältnis der Dauer des Aktivierungs- oder Passivierungsschritts zur Dauer des Entfernens zwischen 0,1 und 10 und vorzugsweise zwischen 0,5 und 2 variiert.

6. Verfahren nach einem der vorhergehenden Ansprüche, wobei das erste Material A ein Siliziumnitrid Si3N4 und das zweite Material B Siliziumoxid SiO2 ist.

7. Verfahren nach einem der vorhergehenden Ansprüche, wobei die ersten und zweiten Untergruppen (21,22) des Behandlungssystems in konzentrischen Ringen angeordnet sind:
- wobei die erste Unterbaugruppe (21) zwischen drei und sechs Plasmaquellen umfasst, die in einem zentralen Ring angeordnet sind, wobei jede Plasmaquelle eine Entladungskammer umfasst,
- wobei die zweite Unterbraugruppe (22) zwischen drei und acht Plasmaquellen umfasst, die in einem zweiten Ring angeordnet sind, der den zentralen Ring umgibt, wobei jede Plasmaquelle zwei Entladungskammern in Reihe umfasst.

8. Verfahren nach dem vorhergehenden Anspruch, wobei das Behandlungssystem einen oder mehrere zusätzliche konzentrische Ringe umfasst, die jeweils einer zusätzlichen Unterbaugruppe entsprechen.

## Claims

1. A method of selective plasma etching of a composite object (3) comprising at least two layers of different materials A and B, the layer of material A at least partially covering the layer of material B, said method using a treatment system comprising:
- a vacuum treatment chamber (10) comprising a support on which the object to be treated is placed; and
- at least two subassemblies (21,22) eac h comprising at least one plasma source (210,220) for generating a plasma, each plasma source (210,220) of a subassembly (21,22) being supplied by a radiofrequency power Pi and by a gas i of flow rate ni, independently of the other sub-assembly or subassemblies; the plasma generated by a subassembly (21) being a partially ionized gas or gaseous mixture of a different chemical nature from the plasma generated by the other subassembly or subassemblies (22),
the method comprising the following steps:
• a step for generating a first plasma by a first of the subassemblies (21), and using the first plasma to treat at least one first region of the object (3) comprising the material B on the surface, said treatment using the first plasma consisting of a passivation or activation step of material B;
• a step for generating a second plasma by a second of the subassemblies (22), and using the second plasma to treat at least one second region of said object (3) comprising the material A on the surface, said treatment using the second plasma consisting of a partial or total removal of material A, said method being able to start either by the passivation or activation step using the first plasma, or by the removal step using the second plasma.

2. The method according to the preceding claim, in which the plasma generation steps are repeated alternately, or with partial or total overlap.

3. The method according to one of the preceding claims, in which the plasma generation steps are repeated with a partial overlap of the steps of at most 25%.

4. The method according to one of the preceding claims, in which the steps for treatment using the first plasma and treatment using the second plasma are carried out alternately at a frequency varying between 0.5 seconds and 120 seconds, and preferably from 2 to 30 seconds, so as to repeat the sequence of said steps a plurality of times until the desired removal of material A is obtained.

5. The method according to one of the preceding claims, in which the ratio of the duration of the activation or passivation step to the duration of the removal varies between 0.1 to 10, and preferably between 0.5 and 2.

6. The method according to any one of the preceding claims, in which the first material A is silicon nitride Si3N4 and the second material B is silicon oxide SiO2.

7. The method according to one of the preceding claims, in which the first and the second subassemblies (21, 22) of the treatment system are arranged in concentric rings:
- the first subassembly (21) having between three and six plasma sources arranged in a central ring, each plasma source comprising a discharge chamber,
- the second subassembly (22) comprising between three and eight plasma sources arranged in a second ring surrounding the central ring, each plasma source comprising two discharge chambers in series.

8. The method according to the preceding claim, wherein the processing system comprises one or more additional concentric ring(s), each corresponding to an additional subassembly.
